# EUROPEAN PATENT APPLICATION

(11) **EP 1 447 715 A2**
(43) Date of publication of application: **18.08.2004**
(21) Application number: 04075433.5
(22) Date of filing: 11.02.2004
(51) Int. Cl.: G03F 7/20

(54) **Lithographic apparatus and method to detect correct clamping of an object**

(30) Priority: 12.02.2003 EP 03075415
(71) Applicant: ASML Netherlands B.V., 5503 LA Veldhoven (NL)
(72) Inventor: Neerhof, Hendrik Antony Johannes, 5629 GK Eindhoven (NL)
(74) Representative: van Westenbrugge, Andries

(57) **Abstract**

Disclosed is a lithographic apparatus (1) comprising a support structure (MT; WT) adapted to clamp an object (W; MA; 5). The support structure (MT; WT) and the object (W; MA; 5) clamped thereon define a compartment. Supply means (11) are connected to the compartment and supply a fluid to the compartment. The supply means (11) comprise a meter (15) to measure a change in at least one of flow velocity of the fluid and pressure of the fluid.

## Description

The invention relates to a lithographic projection apparatus comprising: at least one support structure adapted to clamp an object thereon, the support structure and the object clamped on the support structure defining a compartment, and supply means in communication with said compartment, said supply means being constructed and arranged to supply a fluid to said compartment.

In a lithographic projection apparatus in general, it is of paramount importance to be able to detect whether or not an object has been placed correctly on a support structure. This may for instance be the case for a wafer on a wafer table or for a mask on a mask table. To this end the support structure and/or the object are designed such that together, i.e. with an object placed on the support structure they define a closed space. In a lithographic apparatus working under atmospheric conditions an object is normally connected to a support structure, or "clamped", by evacuating the said closed space. The presence of an object on the support structure is then detected by measuring the pressure in the space or flow from the space. When an object is present, the pressure or flow is different from the case when no object is present. This principle is, however, not feasible for a lithographic apparatus working under relatively high vacuum conditions such as lithographic apparatus using extreme ultraviolet radiation (EUV).

In such a vacuum environment clamping is effected by means of electrostatic forces. Capacitive measurements have been proposed in order to detect whether an object has been placed correctly or has good contact. Such measurements are also not very well feasible, because of the sensitivity to electromagnetic disturbances, or due to the large variety of object materials each having different electrical properties, causing different changes in capacitances.

From the above, it is clear that a problem in the present state of the art is to assess, under vacuum conditions, whether or not an object has been placed correctly on a support structure, like e.g. a wafer on a wafer table, a so called "handler clamp" or an "exposure pin", or a mask on a chuck.

A solution for said problem is for example proposed in the United States patent US 6,576,483 B1 in which a system for supporting and clamping a semiconductor wafer is disclosed. The known system comprises an electrode and a clamp between which the wafer can be clamped. The electrode comprises a cannelure open towards the backside of the wafer, whereby the cannelure exposes said backside to a gas piped through one or more holes provided in the electrode. Said holes are connected in turn to a gas supply means. The cannelure of the known system has a size such that deviation of the wafer from its proper position by more than a threshold partially exposes the cannelure, such that the gas leaks from the cannelure. The supply means comprise a gas flow detector for detecting gas leaking from the cannelure and provide corresponding detection of the wafer deviating from its proper position.

A similar solution is proposed in US 6,401,359 B1, which discloses a system capable of detecting leakage of a heat-transfer gas supplied to a space between a wafer and a mounting stand supporting said wafer in order to determine whether or not said wafer is correctly placed on said mounting stand. The system disclosed in US 6,401,359 B1 uses a flowmeter to perform said detection. The flowmeter measures the flowrate of said gas and compares it by means of a comparator against a threshold value.

A drawback of the known systems is that when used in a lithographic apparatus using high vacuum, the actual detection of a misplaced wafer or mask may take to long, i.e. an unacceptable amount of gas may be released into the vacuum space surrounding said object.

It is therefore an object of the present invention to provide a lithographic apparatus which, under vacuum conditions, at least partially eliminates the above-mentioned drawback or at least to provide an alternative to the known systems.

In particular, it is an object of the present invention to provide a lithographic apparatus in which the correct placement of an object, such as a wafer or a mask, on a support structure, such as a wafer table or a mask table respectively, can be quickly determined irrespective of any EM disturbances and irrespective of the electrical properties of the object.

This object is achieved by a lithographic apparatus according to claim 1. The lithographic apparatus comprises at least one support structure adapted to clamp an object thereon. The support structure and the object clamped on the support structure define a compartment, and the supply means are in communication with said compartment. Said supply means are constructed and arranged to supply a fluid to said compartment, wherein the supply means comprise a meter arranged to measure a change in at least one of flow velocity of the fluid and pressure of the fluid as a function of time, in order to detect whether or not said object is correctly clamped on said support structure.

By pumping a (back-fill) gas in the space between an object (e.g. a wafer) and a support structure (e.g. the wafer table or the support structures mentioned above) it is possible to detect the correct placement of the wafer on the wafer table as explained above. Since, if the back-fill gas can escape from the chamber, which can be determined by measuring the pressure in and/or the flow to the space, the wafer is not correctly placed. By measuring a change in the flow velocity or pressure of the fluid, it is no longer necessary to wait and see whether or not the expected end value of the flow velocity or the pressure of the fluid will be reached. When the object is not clamped correctly on the support structure, the flow velocity will not reach a (near) zero value or the pressure will not reach its expected end value but a lower one. This means in both cases that in case of a misplaced object, the change in flow velocity or in pressure as a function of time will be different, i.e. smaller, compared to the case in which the object is correctly clamped. Such a measurement can be made almost directly after supplying of the fluid to the compartment has begun. When the typical progress of the flow velocity and/or pressure of the fluid in said compartment is determined for a correctly clamped object, an early measurement in time will reveal whether or not the measured value of the flow velocity or pressure, i.e. the actual progress of that value, corresponds with said determined progress.

In a further embodiment said meter is a flow velocity meter connected to a control unit arranged to receive a value representative of the flow velocity of said fluid and arranged to determine a change in the flow velocity of said fluid as a function of time and to compare said change with a predetermined value of said change. This makes it possible to detect at an early stage whether the wafer is correctly placed or not. If the wafer is correctly placed the flow velocity will drop more rapidly than will be the case when the wafer is not correctly placed. Eventually, the flow velocity will reach zero for a correctly placed wafer in a finite period of time, whereas for an incorrectly placed wafer zero will be no more than approached.

In a further embodiment said meter is a pressure meter connected to a control unit arranged to receive a value representative of the pressure of said fluid and arranged to determine a change in the pressure of said fluid as a function of time and to compare said change with a predetermined value of said change. Again there is a difference in the pressure increase as a function of time which makes the detection of a correct placement of the wafer possible. An arbitrary predetermined pressure (and also the predetermined final pressure) will be reached more rapidly in the case of a correct wafer placement.

In a further embodiment the at least one support structure comprises a first support structure for supporting patterning means, the patterning means serving to pattern the projection beam according to a desired pattern, a second support structure for holding a substrate, and wherein the apparatus further comprises a radiation system for providing a projection beam of radiation and a projection system for projecting the patterned beam onto a target portion of the substrate, and wherein at least one of said patterning means or said substrate is clamped on the first support structure or the second support structure, respectively.

In a further embodiment said fluid is a gas comprising argon. Argon is an inert gas which has the advantage that is does not easily react with its environment and is clearly distinguishable from helium used in leak detection. Gases such as, for instance, nitrogen and oxygen are other possibilities.

In a further embodiment the supply means are adapted to increase the pressure in the compartment from a first level to a second level during a predetermined period of time and subsequently decreasing the pressure from the second level to a third level. A temporary increase in pressure on the object will serve as a test to establish whether the clamp force is sufficient to hold the object during accelerations which will be exerted on the object during transportation in the lithographic projection apparatus.

The invention also relates to a method to detect correct clamping of an object on a support structure which support structure and which object clamped on said support structure define a compartment, the method comprising:
- supplying a fluid, in particular a gas to said compartment;
- measuring a change in at least one of flow velocity of said fluid and pressure of said fluid as a function of time.

The invention further relates to a computer program product to be loaded by a control unit in a lithographic projection apparatus according to the present invention, said computer program product comprising instructions and data to allow said control unit to perform the method mentioned above.

The invention further relates to a data carrier provided with a computer program product as mentioned above.

The invention further relates to a support structure for use in a lithographic apparatus according to the present invention.

The term "patterning means" as employed above should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. In the case of a programmable mirror array, the said support structure may be embodied as a frame or table, for example, which may be fixed or movable as required; and
- A programmable LCD array. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

The invention will now be explained in connection with the accompanying drawings, which are only intended to show examples and not to limit the scope of protection, and in which:
Fig. 1 is a schematic general overview of a lithographic projection apparatus ,
Fig. 2 shows a schematic setup of an embodiment of the invention,
Fig. 3 is a graph of the flow velocity versus time for the gas in the supply system,
Fig. 4 is a graph of the pressure in the supply system versus time, and
Fig. 5 illustrates a temporary increase in pressure which is used to test the effectiveness of the clamping.

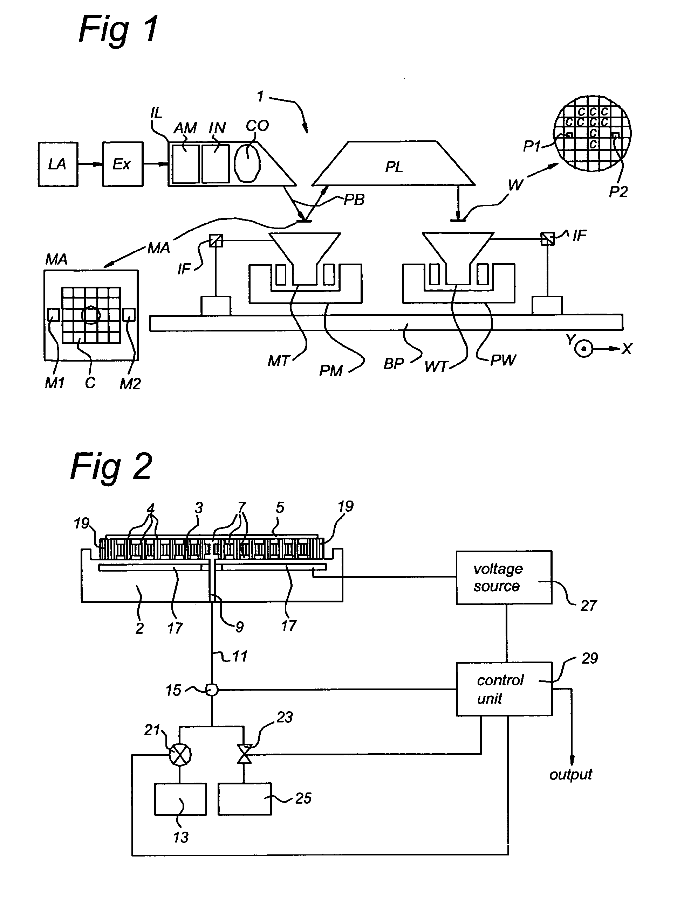

Fig. 1 schematically depicts a lithographic projection apparatus 1 according to a particular embodiment of the invention. The apparatus comprises:
- a radiation system Ex, IL, for supplying a projection beam PB of radiation (e.g. EUV radiation) with a wavelength of 11-14 nm. In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W. As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. a laser-produced plasma or a discharge plasma EUV radiation source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Fig. 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed *v*, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

The embodiment shown in Fig. 2 comprises a support structure having a wafer chuck 2 on which a clamp 3 is positioned. On the surface of the clamp 3 protrusions 4 are present which define a support plane for an object to be clamped on the support structure. Between the protrusions 4 spaces 7 are present that are in communication with each other. As shown in the figure, a wafer 5 is placed on the clamp 3. The assembly of the wafer chuck 2, the clamp 3 and the wafer 5 defines a compartment comprising the spaces 7, which compartment is connected to a fluid storage chamber 13 via an inlet 9 and a supply channel 11. Preferably, the fluid used is a gas comprising argon and the invention will hereinafter be described according to this preferred embodiment. A sealing portion 19, arranged to prevent gas from entering the space housing the assembly is located between the wafer 5 and the wafer chuck 2. In the supply channel 11, a meter 15 is provided for measuring either the gas flow through the supply channel 11 or the pressure in the compartment. It is possible to change the pressure in the compartment by use of, for instance, a pump or a (reduction) valve 21 present in the supply channel 11.

The pump or valve 21 in the example of figure 2 is arranged to supply a so-called "back-fill gas" to the compartment. Moreover, a further valve 23 is provided in a branch of the supply channel 11 that is connected to a vacuum chamber 25. By opening the valve 23 any back-fill gas present in the compartment may be sucked away. The pump 21 is arranged to operate in two ways: i.e. it is able to increase and decrease the pressure in the compartment. Operated in the latter way, the pump 21 will remove the back-fill gas from the compartment. An electrode 17 is provided in the wafer chuck 2 which is adapted to exert an electrostatic force on the wafer 5 that attracts and consequently clamps the wafer 5 onto the clamp 3. To that end, the electrode 17 is supplied with a suitable supply voltage from a voltage source 27. In practice, this electrode 17 may be split in several electrode planes. One electrode plane is located in the clamp 3 and attracts the wafer 5 to the clamp 3 and with another electrode plane, also located in the clamp 3, the clamp 3 is clamped onto the wafer chuck 2. Another electrode plane, a ground electrode, is located in between the wafer chuck 2 and the clamp 3.

If the wafer 5 is clamped correctly the compartment should be substantially gas-tight. Here the term substantially gas-tight is used, as in practice there will always be some very small amount of gas leaking from the compartment.

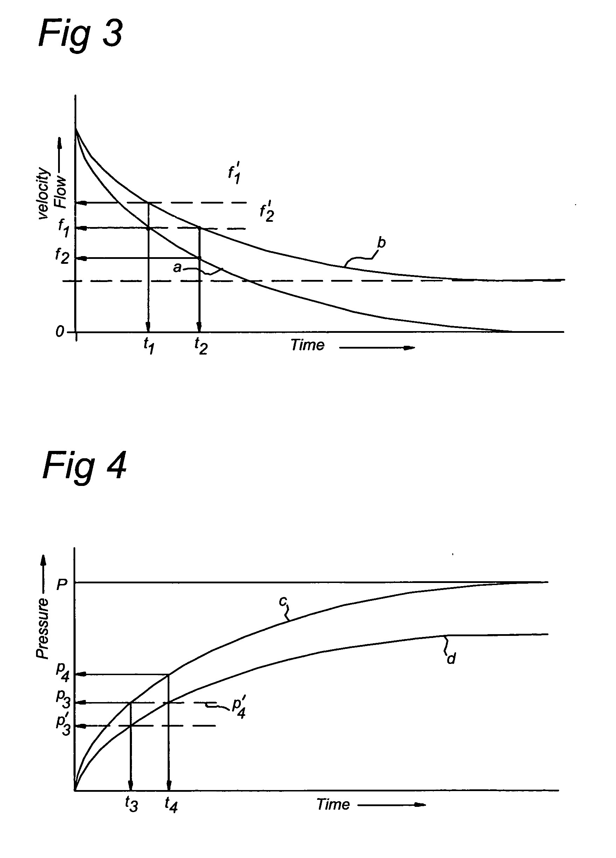

After placing the wafer 5 on the clamp 3 either the flow or the pressure in the supply channel 11 is measured by the meter 15. This measurement is carried out as a function of time so two subsequent measurements will be taken in a time interval. If the flow does not reach a predetermined value, which preferably should be zero, and/or the pressure does not reach a predetermined pressure, which can be the end pressure, sufficiently fast, then it may be concluded that gas is leaking between the clamp 3/sealing portion 19 and wafer 5, which may be caused by misplacing the wafer 5 on the clamp 3. This will be discussed in more detail with reference to figures 3 and 4.

A control unit 29 is provided, connected to the voltage source 27, the meter 15, the pump 21 and the valve 23. The control unit 29 is arranged to operate these components correctly in accordance with settings e.g. received from an operator, and to receive measurement values/operation conditions in return.

Moreover, the control unit 29 has an output to provide suitable output data to the operator, e.g. in the form of data for a printer (not shown), a monitor (not shown), etc. The control unit 29 may be implemented as a computer with suitable software, or as a controller with suitable analog and/or digital circuits. Moreover, the control unit 29 may actually comprise two or more sub-units each designed to perform one or more tasks.

In Fig. 3 and 4 the process of detecting correct placement of the wafer 5 is illustrated in more detail. Fig. 3 shows a graph representing the relationship between the flow velocity as a function of time for two cases. The curve labeled with an "a" represents the progress of the flow velocity in time in case that the wafer 5 is correctly clamped. It can be seen that as time progresses the flow velocity approaches zero and the compartment is substantially gas-tight, i.e. no gas is leaking from the compartment. The curve labeled with a "b", on the other hand, represents the case that the wafer 5 is not correctly clamped and the flow velocity does not reach a (near) zero value. This indicates that there is leakage of gas from the compartment and consequently that the wafer 5 is probably misplaced.

Similar considerations as described above apply to Fig. 4 in which the pressure measured in the supply channel 11 is plotted versus time. When the wafer 5 is correctly placed the pressure approaches a final pressure P as indicated by line "c". When this final pressure is not obtained sufficiently fast (curve "d"), this again means that there may be a wafer placement problem.

As can be clearly seen in both Fig. 3 and 4, the slopes of the curves b and d are quite different from the related curves a and c respectively. The slope of curve a is calculated as (f₂-f₁)/(t₂-t₁) and the slope of curve b is calculated as (f'₂-f'₁)/(t₂-t₁). The slope of curve c is calculated as (p₄-p₃)/(t₄-t₃) and the slope of curve d is calculated as (p'₄-p'₃)/(t₄-t₃).

This means that by measuring a change in the flow velocity or pressure of the gas, it can be quickly determined whether or not the progress in flow velocity or pressure corresponds to the expected progress thereof. In particular it is no longer necessary to wait and see whether or not the expected end value of the flow velocity or the pressure of the gas will be reached. A measurement of change or progress can be made almost directly after supply of the gas to the compartment has begun. When the typical progress of the flow velocity and/or pressure of the gas is determined for a correctly clamped object, an early measurement in time will reveal whether or not the measured value of the flow velocity or pressure, i.e. the actual progress of that value, corresponds with said determined progress.

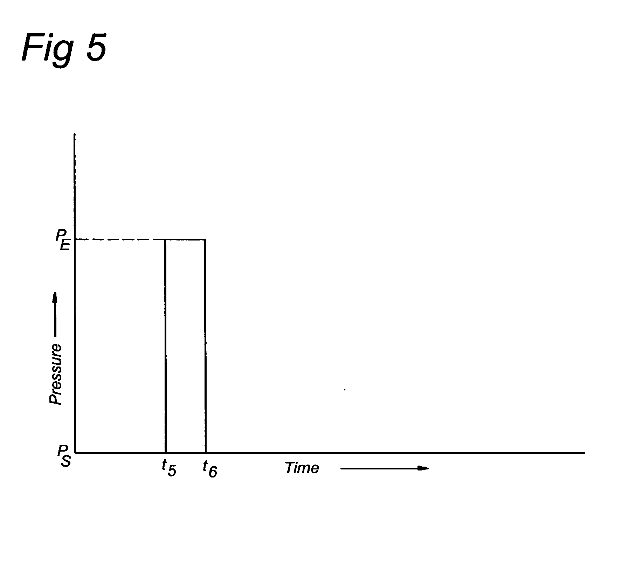

Fig. 5 illustrates that in order to determine how firm the clamping between the wafer 5 and the clamp 3 is, the pressure of the gas in the compartment may, from a time t5 onwards temporarily be increased to an elevated pressure P_{E}, by use of pump 21. From a time t6 onwards the pressure is returned to the starting pressure (i.e. the pressure before t5) P_{S}. The increase in pressure (and subsequent decrease in pressure, though the latter is not strictly necessary) serves as a way to test that the wafer 5 is clamped sufficiently strong and will remain on the clamp during, for instance, transportation. The test works as follows: During the increase in pressure, this quantity is closely monitored by the meter 15 that for this purpose operates as a pressure meter. If the compartment is (substantially) gas-tight, the meter 15 will display the increase in pressure almost instantly. If not, this indicates leakage and a wrongly placed wafer 5.

Alternatively the meter 15 may be a flow velocity meter. Some time after the pressure increase, the flow velocity must be zero when the compartment is (substantially) gas-tight, indicating a correct wafer placement. Naturally, other pulse shapes than the pulse shape shown in Fig. 5 are possible.

Whilst we have described above a specific embodiment of the invention it will be appreciated that the invention may be practiced otherwise than described. The description is not intended to limit the invention. In particular, it will be appreciated that the invention may be used in either or both the mask or substrate stage of a lithographic apparatus.

## Claims

1. A lithographic apparatus (1) comprising:
- at least one support structure (MT; WT) adapted to clamp an object (W; MA; 5) thereon, the support structure (MT; WT) and the object (W; MA; 5) clamped on the support structure (MT; WT) defining a compartment, and
- supply means (11) in communication with said compartment, said supply means (11) being constructed and arranged to supply a fluid to said compartment,
wherein the supply means (11) comprise a meter (15) arranged to measure a change in at least one of flow velocity of the fluid and pressure of the fluid as a function of time, in order to detect whether or not said object (W; MA; 5)is correctly clamped on said support structure (MT; WT).

2. An apparatus (1) according to claim 1, wherein said meter (15) is a flow velocity meter connected to a control unit arranged to receive a value representative of the flow velocity of said fluid and arranged to determine a change in the flow velocity of said fluid as a function of time and to compare said change with a predetermined value of said change.

3. An apparatus (1) according to claim 1, wherein said meter (15) is a pressure meter connected to a control unit arranged to receive a value representative of the pressure of said fluid and arranged to determine a change in the pressure of said fluid as a function of time and to compare said change with a predetermined value of said change.

4. An apparatus (1) according to any of the preceding claims, in which the at least one support structure comprises:
- a first support structure (MT) for supporting patterning means (MA), the patterning means (MA) serving to pattern the projection beam (PB) according to a desired pattern,
- a second support structure (WT) for holding a substrate (W; 5)
and wherein the apparatus (1) further comprises:
- a radiation system for providing a projection beam (PB) of radiation and
- a projection system (PL) for projecting the patterned beam onto a target portion of the substrate (W; 5), and wherein
at least one of said patterning means (MA) or said substrate (W; 5) is clamped on the first support structure (MT) or the second support structure (WT), respectively.

5. An apparatus (1) according to any of the preceding claims, wherein said fluid is a gas comprising argon.

6. An apparatus (1) according to any of the preceding claims, wherein the supply means (11) are adapted to increase the pressure in the compartment from a first level to a second level during a predetermined period of time and subsequently decreasing the pressure from the second level to a third level.

7. An apparatus (1) according to claim 6, wherein the pressure levels are in the range of 8 mBar and 12 mBar, preferably 10 mBar.

8. An apparatus (1) according to claim 6 or 7, wherein the period of time is in the range of 1 s and 30 s.

9. Method to detect correct clamping of an object (W; MA; 5) on a support structure (MT; WT), which support structure (MT; WT) and which object (W; MA; 5) clamped on said support structure (MT; WT)define a compartment, the method comprising:
- supplying a fluid, in particular a gas to said compartment;
- measuring a change in at least one of flow velocity of said fluid and pressure of said fluid as a function of time.

10. Computer program product to be loaded by a control unit in a lithographic apparatus (1) according to any of the claims 1-8, said computer program product comprising instructions and data to allow said control unit to perform the method according to claim 9.

11. Data carrier provided with a computer program product according to claim 10.

12. Support structure (MT; WT) for use in a lithographic apparatus according to any of claims 1-8.
